Europäisches Patentamt

European Patent Office

Office européen des brevets

(19)

(11) Publication number: **0 013 128**
**B1**

# EUROPEAN PATENT SPECIFICATION

(12)

(45) Date of publication of patent specification: **25.07.84**

(21) Application number: **79302963.8**

(22) Date of filing: **19.12.79**

(51) Int. Cl.³: **H 01 L 29/78,**
**H 01 L 29/10, G 11 C 19/28**

(54) **Charge-coupled device.**

(30) Priority: **27.12.78 JP 164995/78**

(43) Date of publication of application:
**09.07.80 Bulletin 80/14**

(45) Publication of the grant of the patent:
**25.07.84 Bulletin 84/30**

(84) Designated Contracting States:
**DE NL**

(56) References cited:
**US - A - 3 829 885**
**US - A - 4 027 382**

**PATENT ABSTRACTS OF JAPAN, vol. 1, no.**
**127, 21-10-1977; page 5548 E 77**
**IEEE JOURNAL OF SOLID STATE CIRCUITS, vol.**
**SC-11, no. 5, october 1976, New York US J.L.**
**FAGAN et al.: "A 16-kbit nonvolatile charge**
**addressed memory" pages 631-636**

(73) Proprietor: **FUJITSU LIMITED**
**1015, Kamikodanaka Nakahara-ku**
**Kawasaki-shi Kanagawa 211 (JP)**

(72) Inventor: **Tohgei, Ryoiku**
**23-6, Narusedai 2-chome**
**Machida-shi, Tokyo 194 (JP)**

(74) Representative: **Abbott, Leonard Charles et al,**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a charge-coupled device according to the first part of claim 1. Such a device is known from US—A—4 027 382.

A charge-coupled device (CCD) of this invention can effectively be applied to devices such as image sensors, shift registers, memories, etc.

In general, a charge-coupled device consists basically of a semiconductor substrate, an insulating layer covering the substrate, and a plurality of electrodes arranged on the insulating layer for transferring carriers. If the semiconductor substrate is of p-type material, a positive voltage on an electrode creates a depression layer and then a potential well is created near the surface of the semiconductor under the insulating layer for storing minority carriers, i.e., electrons, which represent information. When the positive voltage is shifted to an adjacent electrode, the stored information moves correspondingly.

In the prior art, various $CCD_s$ have been developed in order to improve the charge-transfer efficiency and to simplify the electrode-structure (see, for example, the article by R. H. Krambeck, R. H. Walden and K. A. Picker, "Implanted-Barrier Two-Phase Charge-Coupled Device", in Applied Physics Letters, Volume 19, No. 12, 1971 and the article by W. F. Kosonocky" and J. G. Carnes, "Charge-Coupled Digital Circuits" in ISSCC 71/Friday, February, 1971 pp. 162 to 163).

However, these $CCD_s$ of the prior art have a disadvantage of volatility with respect to carriers which represent information. That is, when power applied to an electrode is turned off, the depression region and thus the potential well under the electrode in the substrate immediately vanishes and the carriers stored in the potential well are diffused through the substrate. Therefore, the $CCD_s$ of the prior art cannot be used as devices which require nonvolatile storage of information even when the clock pulse applied to the electrode is instantaneously stopped due to instantaneous power failure or noise.

Nonvolatile $CCD_s$ were proposed by the applicant of the present invention prior to this application. In one of the known nonvolatile $CCD_s$ (Japanese Patent Application No. 53—88874 filed on July 20, 1978), a plurality of storage regions are provided each of which is adjacent to one of the channel regions under the electrodes. These storage regions are diffusion regions having a conductivity opposite to that of the semiconductor substrate and are isolated from the circumferential material so as to be in a floating state. Each storage region for storing one bit of information is related to an adjacent channel region for storing one bit of information in a one-one correspondence. With this CCD, even if a clock pulse to be applied to an electrode for transferring carriers is not applied due to instantaneous power failure or noise, the carriers being transferred through the channel region under the electrode will be stored in the adjacent storage region for a certain time determined by both the amount of the stored carriers and the leakage current. Because each storage region should be provided adjacent to one of the channel regions, and each channel region, which is formed under one of the electrodes when a clock pulse is applied thereto, can not be reduced, the CCD of this type has a larger total area than the volatile CCD because of the size of the newly provided storage regions. Thus, it is inevitable that the degree of integration will be reduced with this nonvolatile CCD.

Another nonvolatile CCD prior to this invention was also proposed (Japanese Patent Application No. 53—91370 filed on July 26, 1978), in which the structure of electrodes was improved. In this CCD, besides the electrodes on the insulating layer for transferring carriers through channel regions which were formed near the surface of the semiconductor substrate under these electrodes, other electrodes for forming storage regions were provided. Each of the storage-region forming electrodes is adjacent to one of the channel-region forming electrodes. Therefore, each of the storage regions is adjacent to one of the channel regions. With this CCD, when a clock pulse to be applied to an electrode for transferring carriers is not applied due to instantaneous power failure or noise, another clock pulse for forming a storage region is applied to the storage-region forming electrode adjacent to the electrode for forming the channel region, whereby, a potential well is created near the surface of the semiconductor substrate under the storage region forming electrode. Thus, the carriers being transferred through the channel are stored in the potential well. The voltage applied to the electrodes for forming storage regions may be an appropriate level of D.C. voltage alternative to the clock pulse. However, this second type of known nonvolatile CCD also requires a new area for storing carriers so that the degree of integration is reduced. In addition, since this CCD is a Surface-channel CCD (SCCD), that is, since the storage regions and the channel regions are formed near the surface of the semiconductor substrate, the carriers are affected by the surface states causing the storage time to reduce. Further, this CCD requires additional power supply for providing clock pulses or a constant voltage to form the storage regions other than the power supply for providing clock pulses for transferring carriers, which results in a high manufacturing cost and high power consumption. Thus, the above mentioned two types of nonvolatile $CDD_s$ are not sufficient in view of the degree of integration, storage time, manufacturing cost, or power consumption.

A charge-coupled device according to the present invention for transferring carriers comprises a semiconductor substrate of one conducting type, an insulating layer covering the semiconductor substrate, a plurality of electrodes arranged on the insulating layer in a two-layer structure with adjacent electrodes forming the two layers, the carriers being transferred by applying multi-phase driving pulses to the electrodes and first regions of the same conductivity type as the semiconductor substrate and second regions, said first and second regions being arranged between the semiconductor substrate and the insulating layer in an alternating sequence in the direction of carrier transfer, each pair of first and second regions being arranged to be substantially covered by one of the electrodes, each of the first regions acting as a barrier region and each of the second regions acting as a storage region, characterized in that the concentration of impurity ions in the said first regions is lower than the concentration of impurity ions in the said semiconductor substrate, and in that the second regions are of the opposite conductivity type to the semiconductor substrate, store the carriers when no voltage is applied to the electrodes for a predetermined time and are electrically isolated from the adjacent second regions.

A charge-coupled device embodying the invention has a relatively long storage time and this is obtained without reducing the degree of integration and without requiring an additional power supply for forming the storage regions.

In order that the invention may be better understood, an example of a charge-coupled device embodying the invention will now be described with reference to the accompanying drawings, in which:—

Figure (a) illustrates a cross sectional view of the nonvolatile CCD along the carrier-transfer direction, according to one embodiment of the present invention;

Figure (b) is a graphic diagram illustrating the potential distribution in the CCD of Figure (a) before any clock pulse is applied;

Figure (c) is a graphic diagram illustrating the potential distribution in the CCD of Figure (a) when a clock pulse is applied to one of the electrodes;

Figure (d) is a graphic diagram illustrating the potential distribution in the CCD of Figure (a) when another clock pulse is applied to another electrode; and,

Figure (e) is a graphic diagram illustrating the potential distribution and information storage in the CCD of Figure (a) upon power failure.

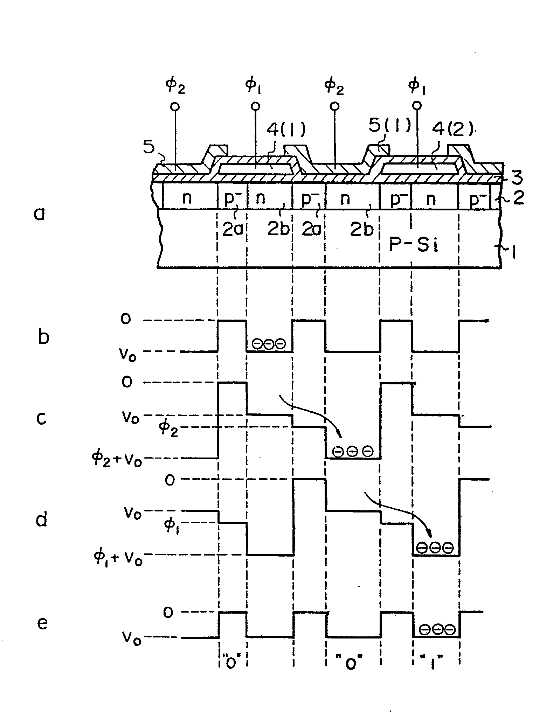

Referring to Figure (a), the steps of manufacturing a nonvolatile CCD according to one embodiment of the present invention are as follows. At first, on a semiconductor substrate 1 of p-type silicon, according to the invention, an epitaxial layer of the same conducting type is grown. The concentration of the impurity material in the epitaxial-growth layer is lower than that in the semiconductor substrate 1. In the figure, the epitaxial-growth layer having lower concentration is represented as "p⁻". In the second step, impurity islands having opposite conductive type are formed in the epitaxial-growth layer by means of selective diffusion or selective ion implantation. Thus, as illustrated in Figure (a), a semiconductor layer 2 can be obtained which has alternately arranged p⁻-type regions 2a and n-type regions 2b. Each n-type region 2b is completely surrounded by the adjacent two p⁻-type regions 2a and the p-type substrate 1 so that the region 2b is in a floating state or in an electrically isolated state. The third step is to form an insulating layer 3 of silicon dioxide on the above-mentioned semiconductor layer 2. In the fourth step, every other pair of the p⁻-type regions 2a and n-type regions 2b in the semiconductor layer 2 is covered through the insulating layer 3 by an electrode 4 to which first-phase clock pulses are to be applied. At last, after insulating the electrode 4, another electrode 5 is provided to cover, through the insulating layer 3, every other pair adjacent to the above-mentioned pair of p⁻-type and n-type regions. Second-phase clock pulses are to be applied to the electrode 5. Although two types of regions 2a and 2b are provided in the semiconductor layer 2 near the surface of the p-type semiconductor substrate 1, it should be noted that the total size of the thus obtained CCD according to the present embodiment is not greater than the total size of the prior volatile CCD, because the size of the carrier-transferring electrode 4 or 5 is not greater than the electrode of the prior volatile CCD. The ratio of the p⁻-type area to the n-type area in preferably from 1:1 to 1:2. During the carrier transferring operation, the p⁻-type regions 2a function as barrier regions and the n-type regions 2b as storage regions.

The operation of the nonvolatile CCD of this embodiment is as follows. Figures (b) through (e) are graphic diagrams of the potential distributions in the CCD of Figure (a) in various states. In this embodiment, since the carriers to be transferred through the semiconductor layer 2 are negative charges, in other words, since they are electrons, the potential level in the figures must be understood as the potential level for electrons. When no clock pulse is applied to the electrodes 4 and 5, the potential level at the p⁻-type regions 2a is higher than the potential level at the n-type regions 2b as illustrated in Figure (b). This potential difference in the semiconductor layer 2 is caused by the p-n junctions between each p⁻-type region 2a and the adjacent n-type region 2b. When no voltage is applied to the electrodes, the potential at all the p⁻-type regions 2a is assumed to be zero volt and the potential at all the n-type regions 2b be $V_0$ volts. After introducing carriers or electrons by irradiation of light or by electrical injection into the semiconductor layer 2, a

voltage $\phi_2$ is then applied to the electrodes 5. The potential distribution in the semiconductor layer 2 in this state is illustrated in Figure (c). The absolute value of the voltage $\phi_2$ must be greater than the absolute value of the voltage $V_o$. As can be seen from Figure (c), the potential at the $p^-$-type regions 2a under the electrodes 5 is $\phi_2$ and the potential at the n-type regions 2b under the electrodes 5 is $V_o+\phi_2$. Since no voltage is applied to the electrodes 4 during the term when the voltage $\phi_2$ is applied to the electrode 5, the voltage at the $p^-$-type regions 2a and at the n-type regions 2b both under the electrodes 4 are zero and $V_o$ volts respectively. Thus, potential wells of step configuration are created as illustrated in Figure (c). If the carriers are present in the n-type region 2b under the electrode 4(1) as illustrated in Figure (b), these carriers will then move to the lower potential region and reach the n-type region 2b under the electrode 5(1) which is the lowest potential region. Then, the voltage applied to the electrodes 4 is turned to $\phi_1$ volts and the voltage applied to the electrode 5 is turned to zero volt. At this time, the potential at the p-type regions 2a and the n-type regions 2b both under the electrodes 4 become $\phi_1$ volts and $\phi_1+V_o$ volts respectively and the potential of the p-type regions 2a and the n-type regions 2b both under the electrodes 5 become zero volt and $V_o$ volts respectively. Thus, potential wells of step configuration as illustrated in Figure (d) are obtained. The carriers in the region 2b under the electrode 5(1) will then be transferred to the region 2b under the electrode 4(2) adjacent to the electrode 5(1). The voltages $\phi_1$ and $\phi_2$ may have the same value with a different phase of 180°. By applying the voltage $\phi_1$ and $\phi_2$ to the respective electrodes 4 and 5 alternately, the carriers are transferred in the charge-transfer direction (right direction in the figure) through the semiconductor layer 2 under the electrodes 4(1), 5(1), 4(2), ... sequentially.

In the course of the above-described charge-transfer process, when the voltages or driving pulses $\phi_1$ and $\phi_2$ are not applied to the electrodes 4 and 5 due to power failure or noise, then the potential wells of step configuration formed in the semiconductor layer 2 vanish and the potential distribution in the layer 2 becomes the state as illustrated in Figure (e) which is the same as in Figure (b). The carriers, which were present in the n-type region 2b under the electrode 4(2) before the power failure or noise as illustrated in Figure (d), are stored in the same n-type region 2b because the potential at the n-type region 2b is kept lower than the potential at the adjacent p-type regions 2a. If no carrier is present in the layers under the other electrodes, no carrier is stored in the n-type regions 2b under these electrodes. Since each of the n-type regions 2b is isolated from the circumferential material or adjacent portions and is formed in a floating state, charges stored in some regions 2b are kept for a predetermined time, and a no-charge state in the other regions 2b is kept for a predetermined time without charge accumulation from the circumferential material. As a result, the information "0" in the regions having no carriers as well as the information "1" in the regions having carriers are stored in the respective regions even when a power failure occurs. Thus, since the n-type regions 2b function as charge-storage regions, a nonvolatile CCD is realized.

Since most of the carriers stored in the storage regions 2b are apart from the surface of the semiconductor substrate 1 because the information is basically held in a junction capacitance, the state at the surface of the substrate 1 has almost no influence on the carriers stored in the regions 2b. Therefore, the storage time of the CCD of this embodiment is larger than that of the prior Surface-channel CCD of a nonvolatile type. The storage time according to the present invention reaches from several seconds to several minutes. Although the nonvolatility is not permanent as in the other nonvolatile memories, it is possible, upon power failure, to switch to the other power supply within the storage time. Also, during the storage time, the power failure may be recovered.

For example, the semiconductor substrate 1 may be n-type silicon in place of p-type silicon as used in the aforementioned embodiment. In this case, the barrier regions must be $n^-$-type regions formed by epitaxial growth and the storage regions must be p-type regions formed by diffusing or ion implantation. In the $CCD_s$ having an n-type substrate, the carriers to be transferred are holes.

Also, the semiconductor layer 2 may be formed without forming the epitaxial layer but by directly diffusing impurity material on the selected surface of the semiconductor material 1 to form storage regions. Ion implantation may of course be used in place of the diffusion process.

Further, the driving pulses are not restricted to two-phases pulses but may be multi-phase.

From the foregoing description, it will be understood that, according to the present invention, a new-improved nonvolatile CCD which has a relatively long storage time can be obtained without reducing the degree of integration and without requiring additional power supply for forming storage regions.

## Claims

1. A charge-coupled device for transferring carriers comprising a semiconductor substrate (1) of one conducting type, an insulating layer (3) covering the semiconductor substrate (1), a plurality of electrodes (4, 5) arranged on the insulating layer (3) in a two-layer structure with adjacent electrodes forming the two layers, the carriers being transferred by applying multi-phase driving pulses to the electrodes (4, 5), and first regions (2a) of the same conductivity type as the semiconductor substrate (1) and second regions (2b), said first and second regions being arranged between the semiconductor substrate (1) and the insulating layer (3) in an alternating sequence in the direction of carrier transfer, each pair of first and second regions being arranged to be substantially covered by one of the electrodes (4, 5), each of the first regions (2a) acting as a barrier region and each of the second regions (2b) acting as a storage region, characterized in that the concentration of impurity ions in the said first regions is lower than the concentration of impurity ions in the said semiconductor substrate, and in that the second regions (2b) are of the opposite conductivity type to the semiconductor substrate, store the carriers when no voltage is applied to the electrodes for a predetermined time and are electrically isolated from the adjacent second regions.

2. A charge-coupled device as claimed in claim 1, wherein the said carriers have a maximum storage time in each of the second regions in the range from several seconds to several minutes.

3. A charge-coupled device as claimed in claim 1 in which in the second regions, which are electrically in a floating state, the carriers are stored at the junctions defining the floating second regions.

4. A charge-coupled device as claimed in claim 1 wherein the ratio of the length of each first region to that of the respective second region of each pair is in the range from approximately 0.5 to 1.

## Patentansprüche

1. Ladungsgekoppelte Schaltung zum Transfer von Trägern, mit einem Halbleitersubstrat (1) von einer Leitfähigkeitsart, einer isolierenden Schicht (3), die das Halbleitersubstrat (1) bedeckt, einer Anzahl von Elektroden (4, 5), die auf der isolierenden Schicht (3) in zweischichtiger Struktur angeordnet sind, wobei benachbarte Elektroden die beiden Schichten bilden, bei welcher die Träger durch Anwendung von Multiphasen-Treiberimpulsen zu den Elektroden (4, 5) übertragen werden, und mit ersten Bereichen (2a) von gleicher Leitfähigkeitsart wie das Halbleitersubstrat (1) und zweiten Bereichen (2b), wobei die genannten ersten und zweiten Bereiche zwischen dem Halbleitersubstrat (1) und der isolierenden Schicht (3) in Richtung des Trägertransfers in alternierender Folge angeordnet sind, jedes Paar von ersten und zweiten Bereichen so angeordnet ist, daß es im wesentlichen von einer der Elektroden (4, 5) bedeckt ist, jeder erste Bereich (2a) als Grenzschichtbereich wirkt und jeder zweite Bereich (2b) als ein Speicherbereich wirkt, dadurch gekennzeichnet, daß die Konzentration der Verunreinigungsionen in den genannten ersten Bereichen niedriger als die Konzentration von Verunreinigungsionen in dem genannten Halbleitersubstrat ist, und daß die zweiten Bereiche (2b) von entgegengesetzter Leitfähigkeitsart wie das Halbleitersubstrat sind, die Träger speichern, wenn eine vorbestimmte Zeit lang keine Spannung den Elektroden zugeführt wird und von den benachbarten zweiten Bereichen elektrisch isoliert sind.

2. Ladungsgekoppelte Schaltung nach Anspruch 1, bei welcher die genannten Träger in jedem der zweiten Bereiche eine maximale Speicherzeit im Bereich von mehreren Sekunden bis mehreren Minuten haben.

3. Ladungsgekoppelte Schaltung nach Anspruch 1, bei welcher in den zweiten Bereichen, die elektrisch in einem Schwebezustand sind, die Träger in den Grenzschichten gespeichert sind, welche die schwebenden zweiten Bereiche definieren.

4. Ladungsgekoppelte Schaltung nach Anspruch 1, in welcher das Verhältnis der Länge jedes ersten Bereichs zu der des entsprechenden zweiten Bereichs eines Paares im Bereich von etwa 0,5 bis 1 liegt.

## Revendications

1. Dispositif à couplage de charge destiné à transférer des porteurs, comprenant un substrat semiconducteur (1) d'un premier type de conductivité, une couche isolante (3) recouvrant le substrat semiconducteur (1), plusieurs électrodes (4, 5) disposées sur la couche isolante (3) suivant une structure à deux couches dans laquelle des électrodes adjacentes forment les deux couches, les porteurs étant transférés par application d'impulsions de commande polyphasées aux électrodes (4, 5), et des premières régions (2a) du même type de conductivité que le substrat semiconducteur (1) et des deuxièmes régions (2b), lesdites premières et deuxièmes régions étant disposées entre le substrat semiconducteur (1) et le couche isolante (3) suivant une succession alternante dans la direction du transfert des porteurs, chaque paire d'une première et d'une deuxième région étant disposée de façon à être sensiblement recouverte par l'une des électrodes (4, 5), chacune des premières régions (2a) faisant fonction de région de barrière et chacune des deuxièmes régions (2b) faisant fonction de région d'emmagasinage, caractérisé en ce que la concentration en ions d'impureté desdites premières régions est inférieure à la concentration en ions d'impureté dudit substrat semiconducteur, et en ce que les deuxièmes régions (2b) sont du type de conductivité opposé à celui du substrat semiconducteur, emmagasinent les porteurs lorsqu'aucune tension n'est appliquée aux électrodes pendant une durée prédéterminée et sont électriquement isolées vis à vis des deuxièmes régions adjacentes.

2. Dispositif à couplage de charge selon la revendication 1, où lesdits porteurs ont une durée d'emmagasinage maximale dans chacune des deuxièmes régions qui est de l'ordre de plusieurs secondes à plusieurs minutes.

3. Dispositif à couplage de charge selon la revendication 1, où, dans les deuxièmes régions, qui sont électriquement dans un état flottant, les porteurs sont emmagasinés au niveau des jonctions définissant les deuxièmes régions flottantes.

4. Dispositif à couplage de charge selon la revendication 1, où le rapport de la longueur de chaque première région à celle de la deuxième région respective de chaque paire est compris entre environ 0,5 et 1.